# EUROPEAN PATENT APPLICATION

(11) **EP 3 040 763 A1**
(43) Date of publication of application: **06.07.2016**
(21) Application number: 14840144.1
(22) Date of filing: 01.09.2014
(51) Int. Cl.: G02C 7/10, G02B 5/26, G02B 5/28, G02C 7/02

(54) **SPECTACLE LENS**

(30) Priority: 30.08.2013 JP 2013180229
(71) Applicant: HOYA Corporation, Tokyo 161-8525 (JP)
(72) Inventor: NISHIMOTO Keiji, Shinjuku-ku, Tokyo 161-8525 (JP)
(74) Representative: Hoffmann Eitle
(86) International application number: PCT/JP2014/072964
(87) International publication number: WO 2015/030246

(57) **Abstract**

An aspect of the present invention relates to a spectacle lens including coating films, having a characteristic of reflecting light in a specific wavelength region, on both of an object-side surface and an eyeball-side surface of a lens base material, where one or both of the films on the surfaces have a reflectance gradient where a reflectance of the light decreases successively or gradually from a portion positioned downward to a portion positioned upward during use or from the portion positioned upward to the portion positioned downward during use.

## Description

### Technical Field

The present invention relates to a spectacle lens and, more particularly, to a spectacle lens including a coating film for reflecting light in a specific wavelength region with preferable wearing feeling.

### Background Art

Generally, a spectacle lens is manufactured by forming, on a lens base material, a functional film for imparting a desired function. As such a functional film, mirror coating having a high reflectance of visible light while imparting mirror-like gloss on a surface of the lens and thus enhancing fashionability (refer to Patent Literature 1), an ultraviolet rays reflection film for mitigating an amount of ultraviolet rays incident on an eye of a spectacle wearer (refer to Patent Literature 2), and a multilayer film having a reflectivity against short-wavelength light, which is called blue light and has a wavelength of approximately 400 to 500 nm, emitted from a monitor screen of digital devices (Patent Literature 3) are known. A coating film having a characteristic of reflecting light in a specific wavelength region as above is hereinafter referred to as a reflection film.

### Citation List

### Patent Literatures

Patent Literature 1: JP 2000-66149 A
Patent Literature 2: Japanese Patent Specification No. 4524877
Patent Literature 3: JP 2012-093689 A

### Summary of Invention

### Technical Problem

The aforementioned reflection film may be provided on one or both of an object-side surface and eyeball-side surface of a spectacle lens. However, a spectacle lens including the reflection films on both of the surfaces tends to give uncomfortable brightness to a spectacle wearer and thus improvement of wearing feeling thereof is desired.

Therefore, an object of the present invention is to provide a spectacle lens including coating films (reflection films), having a characteristic of reflecting light in a specific wavelength region, on both of the surfaces with preferable wearing feeling.

The aforementioned object is achieved by a spectacle lens including coating films, having a characteristic of reflecting light in a specific wavelength region, on both of an object-side surface and an eyeball-side surface of a lens base material, where one or both of the coating films on the surfaces have a reflectance gradient where a reflectance of the light decreases successively or gradually from a portion positioned downward to a portion positioned upward during use or from the portion positioned upward to the portion positioned downward during use.

Reasons for a spectacle wearer to feel uncomfortable brightness include that light incident on the eyeball-side surface of the spectacle lens from the rear side of the spectacle wearer is reflected by the eyeball-side surface and enters an eye of the spectacle wearer as reflection light or that light incident on the eyeball-side surface is reflected by the object-side surface and enters the eye of the spectacle wearer as return light. On the other hand, in the aforementioned spectacle lens, at least one of the reflection films on both surfaces of the lens has a reflectance gradient where reflectance in an upper region or a lower region of the surface is lower than reflectance in the other region. Since reflection light or return light from a region having a low reflectance is less in volume, an amount of light entering the eye of the spectacle wearer can be relatively reduced as compared to a reflection film having uniform reflectance. In this manner, the present invention allows for improving wearing feeling of the spectacle lens including the reflection films on both of the surfaces.

Furthermore, it is preferable to determine a surface to provide the coating film having a reflectance gradient according to a shape of the lens base material in order to further improve wearing feeling. Shapes of the lens base material include a minus lens where thickness in a center part is thinner than thickness in a peripheral part and a plus lens where thickness in a center part is thicker than thickness in a peripheral part. A preferable aspect for each of the shapes is as described below.

In an aspect with the minus lens (hereinafter referred to as "aspect A"), the coating film, having a reflectance gradient where a reflectance of the light decreases successively or gradually from a portion positioned downward to a portion positioned upward during use, is disposed on an object-side surface.

In another aspect with a minus lens (hereinafter referred to as "aspect B"), the coating film, having a reflectance gradient where a reflectance of the light decreases successively or gradually from a portion positioned downward to a portion positioned upward during use or from the portion positioned upward to the portion positioned downward during use, is disposed on an eyeball-side surface while the coating film without a reflectance gradient is disposed on an object-side surface.

In an aspect with the plus lens (hereinafter referred to as "aspect C"), the coating film, having a reflectance gradient where a reflectance of the light decreases successively or gradually from a portion positioned downward to a portion positioned upward during use, is disposed on an eyeball-side surface.

In another aspect with the plus lens (hereinafter referred to as "aspect D"), the coating film, having a reflectance gradient where a reflectance of the light decreases successively or gradually from a portion positioned downward to a portion positioned upward during use or from the portion positioned upward to the portion positioned downward during use, is disposed on an object-side surface while the coating film without a reflectance gradient is disposed on an eyeball-side surface.

In the aspects B and D, one of the reflection films provided on both of the lens surfaces is a coating film has no reflectance gradient. Even if the film is formed under uniform conditions over the entire surface of the lens, a difference in reflectance of about ±1% is generated within a surface due to influence of surface shape of the lens or the like. Therefore, the aforementioned coating film without a reflectance gradient includes a coating film having a difference in reflectance of about ±1% within a surface.

The reflection film, provided on the other surface than the surface including the reflection film without a reflectance gradient, has a reflectance gradient and thus has different reflectances of light of a specific wavelength in the upper region and lower region. From a perspective of mitigating an amount of light entering an eye of a spectacle wearer, it is preferable that a reflectance of light of the specific wavelength of the reflection film without a reflectance gradient is equivalent to or lower than a reflectance in the region (upper or lower region) having a low reflectance of the reflection film provided on the other surface. This point will be described later. Further, the reflection film provided on the eyeball side in the aspect A and the reflection film provided on the object side in the aspect C will be described later. Note that, in the present invention, a region positioned upward from a fitting point or an optical center during use is referred to as an upper region while a region positioned downward therefrom is referred to as a lower region.

### Advantageous Effects of Invention

The present invention allows for reducing an amount of light entering an eye of a wearer of a spectacle lens including reflection films on both surfaces, thereby allowing for mitigating uncomfortable brightness that the spectacle wearer feels due to the entering light. In this manner, the present invention allows for providing the spectacle lens including the reflection films on both surfaces with preferable wearing feeling.

### Brief Description of Drawings

Figs. 1A to 1E are schematic diagrams of a flow illustrating an exemplary manufacturing method of a reflection film where a reflectance of light in a specific wavelength region varies successively or gradually from a region positioned upward to a region positioned downward during use.
Fig. 2 is a schematic diagram illustrating a preferable combination of coating films disposed on both surfaces of a minus lens base material.
Fig. 3 is a schematic diagram illustrating a preferable combination of coating films disposed on both surfaces of a minus lens base material.
Fig. 4 is a schematic diagram illustrating a preferable combination of coating films disposed on both surfaces of a plus lens base material.
Fig. 5 is a schematic diagram illustrating a preferable combination of coating films disposed on both surfaces of a plus lens base material.
Fig. 6 illustrates a configuration of a vapor deposition apparatus that can be used in an aspect of the present invention.
Fig. 7 is a schematic plane view of a mechanical mask (shielding member) used in an example.
Fig. 8 illustrates film thicknesses (physical film thickness (unit of nm)) and normal incidence average reflectances in a wavelength region of 400 to 500 nm at seven points on a linear line passing through fitting points of respective layers included in a multilayer film formed on an eyeball-side surface in Example 1.
Fig. 9 is a reflection spectrum (normal incidence reflection spectral characteristic) in a wavelength region of 380 to 780 nm of a spectacle lens manufactured in Example 1.
Fig. 10 is a transmission spectrum (normal incidence transmission spectral characteristic) in a wavelength region of 380 to 780 nm of the spectacle lens manufactured in Example 1.
Fig. 11 is a reflection spectrum of reflection light (including return light from the eyeball side) of light obliquely incident from above on the spectacle lens manufactured in Example 1.
Fig. 12 illustrates film thicknesses (physical film thickness (unit of nm)) and normal incidence average reflectances in a wavelength region of 380 to 780 nm at five points on a linear line passing through fitting points of respective layers included in a multilayer film formed on an eyeball-side surface in Example 2.
Fig. 13 is a reflection spectrum (normal incidence reflection spectral characteristic) in a wavelength region of 380 to 780 nm of the spectacle lens manufactured in Example 2.
Fig. 14 is a transmission spectrum (normal incidence transmission spectral characteristic) in a wavelength region of 380 to 780 nm of a spectacle lens manufactured in Example 2.
Fig. 15 is a reflection spectrum of reflection light (including return light from the eyeball side) of light obliquely incident from above on the spectacle lens manufactured in Example 2.

### Description of Embodiments

A spectacle lens according to the present invention includes coating films, having a characteristic of reflecting light in a specific wavelength region, on both of an object-side surface and an eyeball-side surface of a lens base material, where one or both of the coating films on the surfaces have a reflectance gradient where a reflectance of the light decreases successively or gradually from a portion positioned downward to a portion positioned upward during use or from the portion positioned upward to the portion positioned downward during use. As described above, imparting a reflectance gradient as above to at least one of the reflection films provided to both surfaces of the spectacle lens allows for mitigating degradation of wearing feeling of the spectacle lens due to reflection light or return light, entering an eye of a spectacle wearer, of light incident on the spectacle lens from the rear side of the spectacle wearer.

The spectacle lens of the present invention will be further described in detail below.

The spectacle lens according to the present invention includes coating films (reflection films) having a characteristic of reflecting light in a specific wavelength region on both of the object-side surface and the eyeball-side surface of the lens base material. The reflection film may be formed directly on the surface of the lens base material or indirectly on the lens base material via one or more layers of functional films. The lens base material is not specifically limited but may be (meth)acrylic resin, styrene resin , polycarbonate resin, allyl resin, allyl carbonate resin such as diethyleneglycol bis(allylcarbonate)resin (CR-39), vinyl resin, polyester resin, polyether resin, urethane resin obtained through reaction between an isocyanate compound and a hydroxy compound such as diethylene glycol, thiourethane resin obtained through reaction between an isocyanate compound and a polythiol compound, transparent resin obtained by curing a polymerizable composition containing a (thio)epoxy compound having one or more intermolecular disulfide bonds, and the like. Alternatively, inorganic glass may be used. A refractive index of the lens base material may be, for example, approximately 1.60 to 1.75. Note that the refractive index of the lens base material is not limited thereto but may be within the aforementioned range or depart therefrom.

The spectacle lens of the present invention may be various lenses including a monofocal lens, multifocal lens, and progressive refraction lens. For example, in a progressive refraction lens, a near vision region (near vision part) and a progressive region (intermediate region) are included in the aforementioned lower region and a distance vision region (distance vision part) is included in the upper region.

A type of the lens is determined by a surface shape of both surfaces of the lens base material. Further, the lens base material surface may be a convex, concave, or flat surface. In a general lens base material, an object-side surface is a convex surface and an eyeball-side surface is a concave surface. Note that the lens base material used in the present invention is not limited thereto.

The functional film that may be formed between the lens base material and reflection film may be a hard coat layer. Providing a hard coat layer allows for imparting flaw resistance (abrasion resistance) to the spectacle lens and improving durability (strength) of the spectacle lens. As for details of the hard coat layer, for example, paragraphs 0025 to 0028 and 0030 of JP 2012-128135 A may be referred to. Further, as the functional film, a primer layer for enhancing adhesion may be formed. As for details of the primer layer, for example, paragraphs 0029 to 0030 of JP 2012-128135 A may be referred to.

Next, the reflection film will be described.

A reflection film is a coating film having a characteristic of reflecting light in a specific wavelength region as described above. Here, "characteristic of reflecting light" refers to, for example, having a normal incidence reflectance of 1% or more of light of the wavelength region. Light in the specific wavelength region may be, for example, light of the wavelength region of 380 to 780 nm (visible light) or light of the wavelength region of 280 to 400 nm (ultraviolet rays). Further, light in the specific wavelength region may be short-wavelength light (blue light) having a wavelength of approximately 400 to 500 nm as described above.

The reflection film is generally formed as a multilayer film where a high refractive index layer and a low refractive index layer are laminated in an arbitrary combination. More specifically, the multilayer film can be formed by, first determining the thickness of respective layers through optical simulation by a known method based on a refractive index of a film material to form the high refractive index layer and low refractive index layer and a wavelength of light to be reflected and then sequentially laminating the high refractive index layer and low refractive index layer under film formation conditions determined such that the determined thickness is achieved. A coating film having a characteristic of reflecting visible light or ultraviolet rays is known. As for details of the film, for example, a known technique of the aforementioned JP 2000-66149 A or Japanese Patent Specification No. 4524877 may be referred to.

Meanwhile, as for a coating film having a characteristic of reflecting blue light, for example, paragraphs 0023 to 0030 of the aforementioned JP 2012-93689 A may be referred to. Further, a material with a high refractive index to form the high refractive index layer in the coating film having a characteristic of reflecting blue light may be an oxide selected from the group consisting of Ta₂O₅, ZrO₂, TiO₂, Al₂O₃, Y₂O₃, HfO₂, and Nb₂O₅. Meanwhile, a material with a low refractive index to form the low refractive index layer may be SiO₂ or MgF₂. Note that, an oxide and fluoride are expressed here in a stoichiometric composition for convenience; however, an oxide or fluoride where oxygen or fluorine is deficient or excessive as compared to the stoichiometric composition may also be used as a material with a high refractive index or a material with a low refractive index.

The thickness of respective layers included in the multilayer film can be determined through optical simulation as described above. A layer configuration of a multilayer film having a characteristic of reflecting blue light may be, for example, a configuration where a first layer (low refractive index layer), second layer (high refractive index layer), third layer (low refractive index layer), fourth layer (high refractive index layer), fifth layer (low refractive index layer), sixth layer (high refractive index layer), and seventh layer (low refractive index layer) are laminated in the order mentioned from the lens base material side to the outermost side of the lens surface, or a configuration where a first layer (high refractive index layer), second layer (low refractive index layer), third layer (high refractive index layer), fourth layer (low refractive index layer), fifth layer (high refractive index layer), and sixth layer (low refractive index layer) are laminated in the order mentioned from the lens base material side to the outermost side of the lens surface. Preferably, the aforementioned respective layers are formed by vapor deposition using a vapor deposition source including the aforementioned material with a high refractive index or material with a low refractive index as the principal component. Here, the principal component contributes to the largest part of the vapor deposition source and usually contributes to approximately 50 to 100 wt%, or even 90 to 100 wt%. Note that the vapor deposition source may include a minute amount of impurities that inevitably enter and may include another component such as another inorganic substance or a known additive component that supports vapor deposition as long as the component does not degrade the function of the principal component. Further, the vapor deposition in the present invention includes a dry method such as a vacuum vapor deposition method, ion plating method, or sputtering method. In the vacuum vapor deposition method, an ion beam assist method for irradiating with an ion beam may be used concurrently with vapor deposition.

The multilayer film may also include one or more conductive oxide layers, formed by vapor deposition using a vapor deposition source including a conductive oxide as the principal component, in an arbitrary position in the multilayer film in addition to the high refractive index layer and low refractive index layer as described above. Preferably, indium oxide, tin oxide, zinc oxide, or titania that is known as a transparent conductive oxide or a composite oxide thereof is used as the conductive oxide such that transparency of the spectacle lens is not degraded. A conductive oxide especially preferable from a perspective of transparency and conductivity may be indium-tin oxide (ITO). By including the conductive oxide layer, adherence of dust to the charged spectacle lens can be prevented.

In the spectacle lens of the present invention, the reflection film on one surface has a reflectance gradient where a reflectance of light in the specific wavelength region decreases successively or gradually from a portion positioned downward to a portion positioned upward during use or, reversely, from the portion positioned upward to the portion positioned downward during use. In order to impart such a reflectance gradient, it is preferable to dispose a shielding member over the portion positioned upward or downward during use in a surface to be deposited of the spectacle lens when at least one deposition layer is formed in the vapor deposition step of forming the multilayer film. This allows for an amount of accumulated deposition material in the part where the shielding member is place over to be smaller than that in other parts, thereby allowing the thickness of the deposition layer formed in that step to vary successively or gradually from the portion positioned upward to the portion positioned downward during use. An aspect of such a vapor deposition step will be described below based on the drawings.

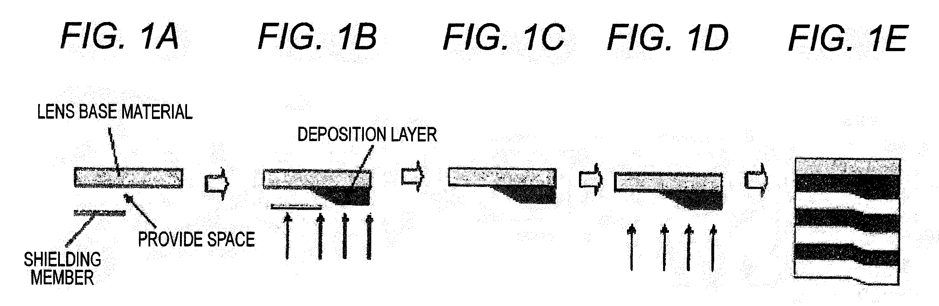

Figs. 1A to 1E are schematic diagrams of a flow illustrating an exemplary manufacturing method of a reflection film where a reflectance of light in a specific wavelength region varies successively or gradually from a region positioned upward to a region positioned downward during use. In Figs. 1A to 1E, a spectacle lens base material is illustrated as a flat surface lens; however, the spectacle lens base material of the present invention is not limited to the one both surfaces of which are flat. This point has been described as above. Further, Figs. 1A to 1E illustrate an aspect where a vapor deposition source is disposed under the spectacle lens base material and a vapor deposition material is evaporated toward a surface of the spectacle lens base material; however, the arrangement of the spectacle lens base material and the vapor deposition material can be vice versa.

First, the lens base material is disposed in a vapor deposition apparatus with a surface thereof to be deposited facing toward the vapor deposition source side. The vapor deposition apparatus may be a known vapor deposition apparatus. An exemplary vapor deposition apparatus that can be used in the present invention will be described in another example to be described later.

When forming a deposition layer with varying thickness within a surface thereof in the vapor deposition apparatus, a shielding member is disposed between the surface to be deposited of the lens base material and the vapor deposition source over the portion positioned upward or the portion positioned downward during use (Fig. 1A). Here, the shielding member is disposed without being in contact with the surface to be deposited of the lens base material but with a space therebetween. When the vapor deposition material evaporates from below in this state, a large amount of vapor deposition material deposits in a portion where there is no shielding member thereover on the surface to be deposited of the lens base material while, in a portion where there is the shielding member thereover, a small amount of vapor deposition material deposits near a boundary with the portion where there is no shielding member thereover. The amount of deposition decreases as it departs from the boundary (Fig. 1B). In this manner, for example when the shielding member is disposed over the portion positioned downward during use, the deposition layer, the thickness of which decreases successively or gradually from the portion positioned upward to the portion positioned downward during use, can be formed. Thereafter, the shielding member is removed (Fig. 1C) and the vapor deposition step is repeated. This allows for forming the multilayer film on the surface to be deposited of the lens base material (Figs. 1D and 1E). Note that the deposition layer having different thicknesses within a surface thereof can be formed at least one or two or more in number in the multilayer film. For example, in one aspect, the thinner the low refractive index layer is, the lower a reflectance of light in a specific wavelength region becomes and the thicker the high refractive index layer is, the higher the reflectance becomes. In this case, forming the low refractive index layer to be thicker in the portion positioned downward during use than in the upper portion or forming the high refractive index layer to be thinner in the portion positioned downward during use than in the upper portion can result in a higher reflectance in the portion positioned downward than in the upper portion. Inversely, in an aspect where a thinner low refractive index layer results in a higher reflectance of light in a specific wavelength region while a thicker high refractive index layer results in a lower reflectance, forming the layers in an inverse manner can result in a higher reflectance in the portion positioned downward than in the upper portion.

Note that disposing and removing the shielding member in an intermediate step in the plurality of vapor deposition steps for forming the multilayer film complicates the manufacturing step. Therefore, from a perspective of simplifying the steps, it is preferable that the vapor deposition step performed with the shielding member disposed is included in the plurality of vapor deposition steps as the first step or as the last step, that is, the step is performed to form the first layer or the uppermost layer of the multilayer film.

In the spectacle lens according to the present invention, the reflection film provided to at least one of the object-side surface and the eyeball-side surface of the lens base material has the aforementioned reflection gradient. The reflection film imparted with the reflectance gradient includes a low reflectance region and a high reflectance region. For example, when one of the region positioned downward from the fitting point during use of the spectacle lens (lower region) and the region positioned upward therefrom (upper region) is the low reflectance region and the other is the high reflectance region, a difference in reflectance of the light in the specific wavelength region in the two regions is preferably 2% or more where a difference in normal incidence average reflectance is given by [(normal incidence average reflectance in the high reflectance region) - (normal incidence average reflectance in the low reflectance region)]. Also from a perspective of preventing a difference in reflection characteristics in both of the regions from greatly influencing an appearance and wearing feeling of the spectacle lens, the difference is preferably 14% or less. Here, the normal incidence average reflectance of light in the specific wavelength region in the high reflectance region or low reflectance region refers to a value of normal incidence average reflectance measured at one or more points in the region. The value may be an average value, maximum value, or minimum value of the values measured at two or more points. The measuring points may be, for example, approximately two to ten points. Moreover, the difference may be a difference between the average value of normal incidence average reflectances measured in a high refractive index region and the average value of normal incidence average reflectances measured in a low refractive index region. Alternatively, the difference may be a difference between the maximum value of normal incidence average reflectance measured in the high refractive index region and the minimum value of normal incidence average reflectance measured in the low refractive index region.

As described above, by imparting varying thicknesses, the reflection film having a reflectance gradient within a surface thereof can be formed. On the other hand, by providing a uniform thickness without imparting varying thicknesses, the reflection film without a reflectance gradient can be formed.

Meanwhile, the shape of a spectacle lens (lens base material) is largely classified into, as described above, a minus lens where the thickness in the center part is thinner than that in the peripheral part and a plus where the thickness in the center part is thicker than that in the peripheral part. In the spectacle lens of the present invention, aspects of arrangement of the coating film having a reflectance gradient when the lens base material is the minus lens includes the aspects A and B while those of the plus lens includes the aspects C and D. The aspects will be further described in detail below.

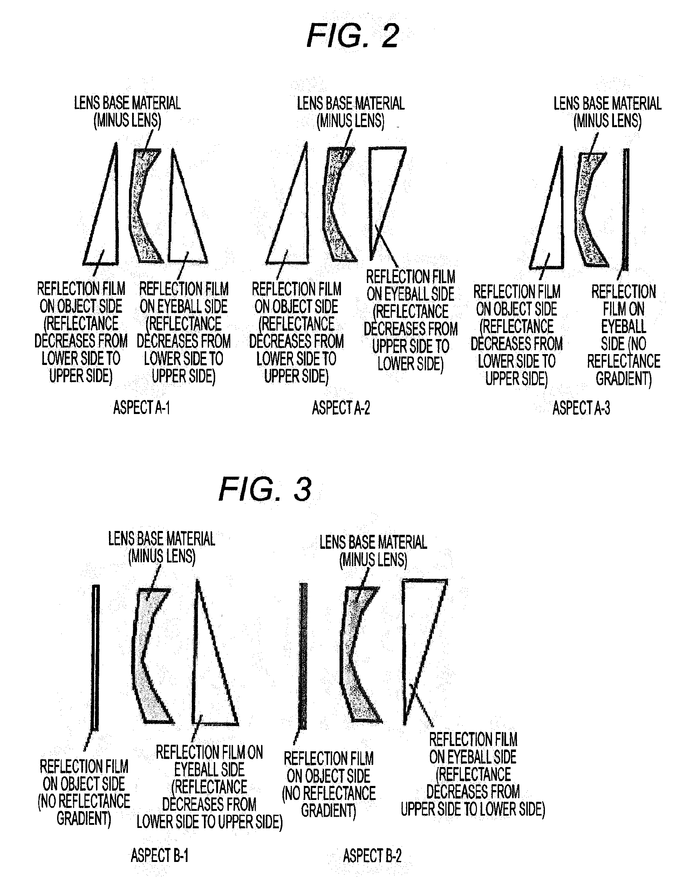

In the aspect A (the lens base material is a minus lens), the coating film having a reflectance gradient is provided at least on the object-side surface of the lens base material. The aspect A includes following aspects A-1 to A-3. Fig. 2 is a schematic diagram illustrating arrangement of a reflection film in the aspects A-1 to A-3.

### <Aspect A-1>

A spectacle lens including, on an object-side surface, a coating film having a reflectance gradient where a reflectance of light in a specific wavelength region decreases successively or gradually from a portion positioned downward to a portion positioned upward during use and, on an eyeball-side surface, a coating film having a reflectance gradient where a reflectance of the light decreases successively or gradually from the portion positioned downward to the portion positioned upward during use.

### <Aspect A-2>

A spectacle lens including, on an object-side surface, a coating film having a reflectance gradient where a reflectance of light in a specific wavelength region decreases successively or gradually from a portion positioned downward to a portion positioned upward during use and, on an eyeball-side surface, a coating film having a reflectance gradient where a reflectance of the light decreases successively or gradually from the portion positioned upward to the portion positioned downward during use.

### <Aspect A-3>

A spectacle lens including, on an object-side surface, a coating film having a reflectance gradient where a reflectance of light in a specific wavelength region decreases successively or gradually from a portion positioned downward to a portion positioned upward during use and, on an eyeball-side surface, a coating film without a reflectance gradient.

Any of the spectacle lenses according to the aspects A-1 to A-3 includes, on the object-side surface, a reflection film having a reflectance gradient where the upper region is the low reflectance region. According to the aspects, light incident on the eyeball-side surface of the spectacle lens from the upper rear side of the spectacle wearer is transmitted by the eyeball-side surface and reflected by the object-side surface. This allows for reducing an amount of light entering an eye of the spectacle wearer as return light. Since a large part of light sources such as illumination light or sunlight is positioned above, the light incident from the rear side of the spectacle wearer includes a large amount of light incident from the upper rear side. Meanwhile, in a minus lens, out of light incident from the upper rear side of the spectacle wearer, light reflected by the eyeball side of the spectacle lens tends not to enter an eye of the spectacle wearer while light transmitted by the eyeball side of the spectacle lens and reaching the object-side surface tends to be reflected by the object-side surface and enter the eye of the spectacle wearer as return light due to the shape of the lens. Therefore, according to the aspects A-1 to A-3 where a portion, reflecting light incident from the upper rear side of the spectacle wearer and thereby providing return light on the object-side surface, is caused to have a lower reflectance, an amount of return light entering the eye of the spectacle wearer can be reduced. Note that, in the aspect A-1, the upper region is the low reflectance region even in the reflection film on the eyeball-side surface. From the above reason, the amount of light entering the eye of the spectacle wearer after reflection, of light incident from the upper rear side of the spectacle wearer, by the eyeball-side surface is not large in quantity; however, some incidence may still occur. The aspect A-1 is advantageous in the point that the amount of light entering the eye of the spectacle wearer after reflection by the eyeball-side surface can also be reduced. On the other hand, in the aspect A-2, the reflection film on the eyeball-side surface has a reverse reflectance gradient to that of the reflection film on the object-side surface and thus the lower region is the low reflectance region. The aspect A-2 is advantageous in the point that, by imparting different types of reflectance gradient to the reflection films on both of the lens surfaces, a change in an appearance or wearing feeling of the spectacle lens due to the reflectance gradient can be cancelled out with a difference in the reflectance gradient of the reflection films on both of the lens surfaces. Meanwhile, in the aspect A-3, the reflection film on the eyeball-side surface has no reflectance gradient. Since the coating film without a reflectance gradient can be easily formed, the aspect A-3 is advantageous from a perspective of manufacturing applicability. The reflection film in the eyeball-side surface in the aspect A-3 is preferably low from a perspective of reducing the amount of return light entering the eye of the spectacle wearer after reflection by the eyeball-side surface. From this regard, the reflectance of light in the specific wavelength region of the coating film on the eyeball-side surface in the aspect A-3 is preferably equal to or lower than a reflectance in the low reflectance region on the object-side surface. More specifically, it is preferable that the normal incidence average reflectance in the specific wavelength region of the coating film on the eyeball-side surface is lower than or equal to the normal incidence average reflectance in the upper region (low reflectance region) of the coating film on the object-side surface.

Meanwhile, in the aspect B (the lens base material is a minus lens), the coating film having a reflectance gradient is provided only on the eyeball-side surface of the lens base material. The aspect B includes following aspects B-1 and B-2. Fig. 3 is a schematic diagram illustrating an arrangement of a reflection film in the aspects B-1 and B-2.

### <Aspect B-1>

A spectacle lens including, on an eyeball-side surface, a coating film having a reflectance gradient where a reflectance of light in a specific wavelength region decreases successively or gradually from a portion positioned downward to a portion positioned upward during use and, on an object-side surface, a coating film having a characteristic of reflecting the light without a reflectance gradient.

### <Aspect B-2>

A spectacle lens including, on an eyeball-side surface, a coating film having a reflectance gradient where a reflectance of light in a specific wavelength region decreases successively or gradually from a portion positioned upward to a portion positioned downward during use and, on an object-side surface, a coating film having a characteristic of reflecting the light without a reflectance gradient.

Any of the spectacle lenses according to the aspects B-1 and B-2 includes a coating film without a reflectance gradient on the object-side surface. The upper region of the coating film on the eyeball-side surface in the aspect B-1 and the lower region of the coating film on the eyeball-side surface in the aspect B-2 are the low reflectance regions. As described above, in a minus lens, it is preferable to prevent the light incident from the upper rear side of the spectacle wearer from entering the eye of the spectacle wearer as return light from the upper side of the object-side surface. From this regard, the reflectance of light in the specific wavelength region of the coating film on the object side of the spectacle lens in the aspects B-1 and B-2 is preferably low. From this regard, the reflectance of light in the specific wavelength region of the coating film on the object-side surface in the aspects B-1 and B-2 is preferably equal to or lower than a reflectance in the low reflectance region on the eyeball-side surface. More specifically, it is preferable that the coating film on the eyeball-side surface has a higher or lower normal incidence average reflectance in the specific wavelength region in the lower region than a normal incidence average reflectance in the specific wavelength region in the upper region positioned upward from the lower region and that the normal incidence average reflectance in the specific wavelength region of the coating film on the object-side surface is lower than or equal to the normal incidence average reflectance in the region having a low normal incidence average reflectance (low reflectance region) in the upper region or lower region of the coating film on the eyeball-side surface.

Note that, the aspect B-1 is advantageous in the point that the amount of light entering the eye of the spectacle wearer after reflection, of light incident from the upper rear side of the spectacle wearer, by the eyeball-side surface can be reduced since the upper region of the eyeball-side surface is the low reflectance region. On the other hand, the aspect B-2 is advantageous in the point that the amount of light entering the eye of the spectacle wearer after reflection, of light incident from the lower rear side of the spectacle wearer, by the eyeball-side surface can be reduced since the lower region of the eyeball-side surface is the low reflectance region.

The aspects where the lens base material is a minus lens have been described above. Contrary to the above, in the aspects C and D, a lens base material is a plus lens.

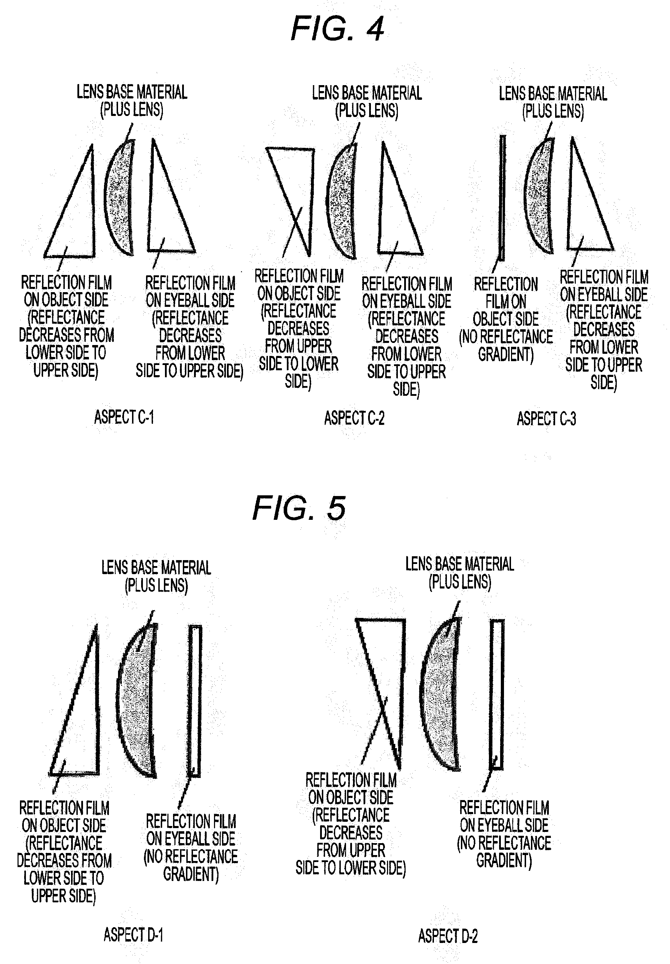

In the aspect C (the lens base material is a plus lens), the coating film having a reflectance gradient is provided at least on the eyeball-side surface of the lens base material. The aspect C includes following aspects C-1 to C-3. Fig. 4 is a schematic diagram illustrating an arrangement of a reflection film in the aspects C-1, C-2.

### <Aspect C-1>

A spectacle lens including, on an eyeball-side surface, a coating film having a reflectance gradient where a reflectance of light in a specific wavelength region decreases successively or gradually from a portion positioned downward to a portion positioned upward during use and, on an object-side surface, a coating film having a reflectance gradient where a reflectance of the light decreases successively or gradually from the portion positioned downward to the portion positioned upward during use.

### <Aspect C-2>

A spectacle lens including, on an eyeball-side surface, a coating film having a reflectance gradient where a reflectance of light in a specific wavelength region decreases successively or gradually from a portion positioned downward to a portion positioned upward during use and, on an object-side surface, a coating film having a reflectance gradient where a reflectance of the light decreases successively or gradually from the portion positioned upward to the portion positioned downward during use.

### <Aspect C-3>

A spectacle lens including, on an eyeball-side surface, a coating film having a reflectance gradient where a reflectance of light in a specific wavelength region decreases successively or gradually from a portion positioned downward to a portion positioned upward during use and, on an object-side surface, a coating film without a reflectance gradient.

Any of the spectacle lenses according to the aspects C-1 to C-3 includes, on the eyeball-side surface, a reflection film having a reflectance gradient where the upper region is the low reflectance region. According to the aspects, light incident on the eyeball-side surface of the spectacle lens from the upper rear side of the spectacle wearer is reflected by the eyeball-side surface. This allows for reducing an amount of light entering an eye of the spectacle wearer. In a plus lens, out of light incident from the upper rear side of the spectacle wearer, light reflected by the eyeball-side surface of the spectacle lens tends to enter the eye of the spectacle wearer while return light from the object-side surface of the spectacle lens tends not to enter the eye of the spectacle wearer due to the shape of the lens. Therefore, according to the aspects C-1 to C-3 where a portion, reflecting light incident from the upper rear side of the spectacle wearer on the eyeball-side surface, is caused to have a lower reflectance, an amount of reflection light entering the eye of the spectacle wearer can be reduced. Note that, in the aspect C-1, the upper region is the low reflectance region even in the reflection film on the object-side surface. From the above reason, the amount of light entering the eye of the spectacle wearer as return light after reflection, of light incident from the upper rear side of the spectacle wearer, by the object-side surface is not large in quantity; however, some incidence may still occur. The aspect C-1 is advantageous in the point that the amount of light entering the eye of the spectacle wearer after reflection by the object-side surface can also be reduced. On the other hand, in the aspect C-2, the reflection film on the object-side surface has a reverse reflectance gradient to that of the reflection film on the eyeball-side surface and thus the lower region thereof is the low reflectance region. The aspect C-2 is advantageous in the point that, by imparting different types of reflectance gradient to the reflection films on both of the lens surfaces, a change in an appearance or wearing feeling of the spectacle lens due to the reflectance gradient can be cancelled out with a difference in the reflectance gradient of the reflection films on both of the lens surfaces. Meanwhile, in the aspect C-3, the reflection film on the object-side surface has no reflectance gradient. Since the coating film without a reflectance gradient can be easily formed, the aspect C-3 is advantageous from a perspective of manufacturing applicability. The reflection film in the object-side surface in the aspect C-3 is preferably low from a perspective of reducing the amount of return light entering the eye of the spectacle wearer after reflection, of light incident from the eyeball side, by the object-side surface. From this regard, the reflectance of light in the specific wavelength region of the coating film on the eyeball-side surface in the aspect C-3 is preferably equal to or lower than a reflectance in the low reflectance region on the eyeball-side surface. More specifically, it is preferable that the normal incidence average reflectance in the specific wavelength region of the coating film on the object-side surface is lower than or equal to the normal incidence average reflectance in the upper region (low reflectance region) of the coating film on the eyeball-side surface.

Meanwhile, in the aspect D (the lens base material is a plus lens), the coating film having a reflectance gradient is provided only on the object-side surface of the lens base material. The aspect D includes following aspects D-1 and D-2. Fig. 4 is a schematic diagram illustrating an arrangement of a reflection film in the aspects D-1 and D-2.

### <Aspect D-1>

A spectacle lens including, on an object-side surface, a coating film having a reflectance gradient where a reflectance of light in a specific wavelength region decreases successively or gradually from a portion positioned downward to a portion positioned upward during use and, on an eyeball-side surface, a coating film having a characteristic of reflecting the light without a reflectance gradient.

### <Aspect D-2>

A spectacle lens including, on an object-side surface, a coating film having a reflectance gradient where a reflectance of light in a specific wavelength region decreases successively or gradually from a portion positioned upward to a portion positioned downward during use and, on an eyeball-side surface, a coating film having a characteristic of reflecting the light without a reflectance gradient.

Any of the spectacle lenses according to the aspects D-1 and D-2 includes a coating film without a reflectance gradient on the eyeball-side surface. The upper region of the coating film on the object-side surface in the aspect D-1 and the lower region of the coating film on the object-side surface in the aspect D-2 are the low reflectance regions. As described above, in the minus lens, it is preferable to prevent the light incident from the upper rear side of the spectacle wearer from entering the eye of the spectacle wearer after reflection from the upper side of the eyeball-side surface. From this regard, the reflectance of light in the specific wavelength region of the coating film on the eyeball side of the spectacle lens in the aspects D-1 and D-2 is preferably low. From this regard, the reflectance of light in the specific wavelength region of the coating film on the eyeball-side surface in the aspects D-1 and D-2 is preferably equal to or lower than a reflectance in the low reflectance region on the object-side surface. More specifically, it is preferable that the coating film on the object-side surface has a higher or lower normal incidence average reflectance in the specific wavelength region in the lower region than a normal incidence average reflectance in the specific wavelength region in the upper region positioned upward from the lower region and that the normal incidence average reflectance in the specific wavelength region of the coating film on the eyeball-side surface is lower than or equal to the normal incidence average reflectance in the region having a low normal incidence average reflectance (low reflectance region) in the upper region or lower region of the coating film on the object-side surface.

Note that, the aspect D-1 is advantageous in the point that the amount of light entering the eye of the spectacle wearer as return light after reflection, of light incident from the upper rear side of the spectacle wearer, by the object-side surface can be reduced since the upper region of the object-side surface is the low reflectance region. Meanwhile, the aspect D-2 is advantageous in the point that the amount of light entering the eye of the spectacle wearer as return light after reflection, of light incident from the lower rear side of the spectacle wearer, by the object-side surface can be reduced since the lower region of the object-side surface is the low reflectance region.

The spectacle lens of the present invention includes the reflection films as described above on both of the lens surfaces. A functional film can be further formed on one or both of the reflection films. Such a functional film may be a water repellent or hydrophilic antifouling layer. As for details, paragraphs 0040 to 0042 of JP 2012-128135 A are to be referred to.

The spectacle lens of the present invention as described above provides a preferable wearing feeling since the lens allows for reducing the amount of light (return light or reflection light), attributable to light incident from the rear side of the spectacle wearer, entering the eye of the spectacle wearer.

### Examples

The present invention will be further described with examples below; however, the present invention is not limited to aspects illustrated in the examples.

### [Example 1]

### 1-1. Selection of lens base material and formation of hard coat layer

As a lens base material, a minus lens (progressive refraction lens) of a plastic lens base material for spectacles with a refractive index of 1.67 (product name: SSV/a product by HOYA Corporation) was used.

A coating liquid for forming a hard coat layer was prepared as follows. An epoxy resin-silica hybrid (product name: COMPOCERAN E102, a product by ARAKAWA Chemical Industries, LTD.) of 20 parts by mass was mixed with an acid anhydride-based curing agent (product name: Curing Agent C2, a product by ARAKAWA Chemical Industries, LTD.) of 4.46 parts by mass and stirred to obtain the coating liquid. This coating liquid was applied to each of the object-side surface and eyeball-side surface of the lens base material using a spin coater such that a predetermined thickness is achieved. The lens base material after application was subjected to baking at 125°C for two hours to form a hard coat layer with a thickness of 1000 to 3000 nm where silica and titania sol are fixed with resin.

The lens base material where the hard coat layer is formed on both of the surfaces as above is hereinafter also referred to as a lens sample.

### 1-2. Formation of multilayer film on eyeball-side surface and object-side surface

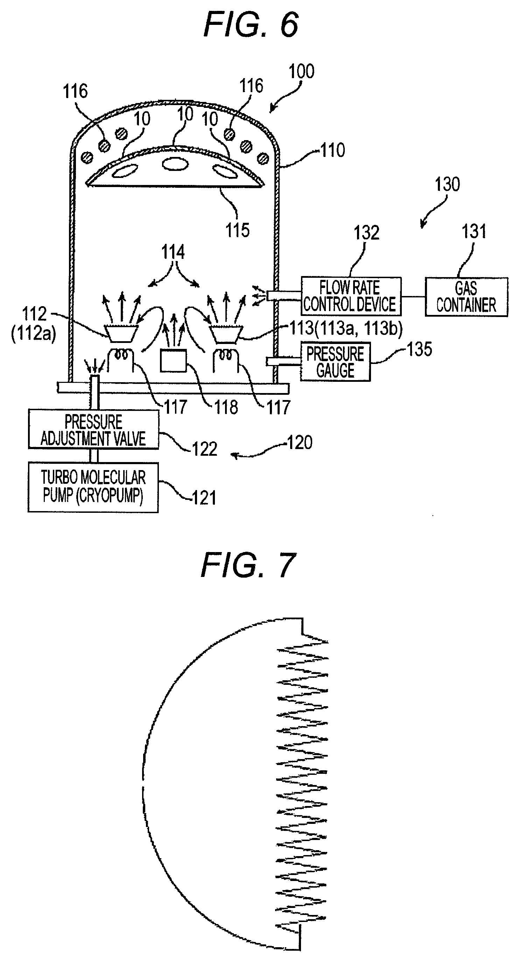

Using a vapor deposition apparatus illustrated in Fig. 6, a multilayer film was formed on each of the eyeball-side surface and object-side surface. In the present example, the multilayer film without a reflectance gradient was formed on the object-side surface (convex surface) and the multilayer film was formed on the eyeball-side surface (concave surface) such that the upper region is the low reflectance region, thereby obtaining the spectacle lens of the aspect B-1.

A configuration of a vapor deposition apparatus illustrated in Fig. 6 will be described below.

A vapor deposition apparatus 100 illustrated in Fig. 6 is capable of successively forming (manufacturing) a plurality of deposition layers. The vapor deposition apparatus 100 is an electron beam vapor deposition apparatus and includes a vacuum chamber 110, an exhaust device 120, and a gas supply device 130. The vacuum chamber 110 includes a sample support 115, on which a lens sample 10 formed with a hard coat layer is mounted, a base material heating heater 116 for heating the lens sample 10 mounted on the sample support 115, and a filament 117 for generating thermions. The base material heating heater 116 may be, for example, an infrared lamp. The base material heating heater 116 heats up the lens sample 10 for releasing gas or evaporating water to ensure adhesion of layers formed on a surface of the lens sample 10.

The vapor deposition apparatus 100 further includes an accommodation part 112 for accommodating a vapor deposition source 112a for forming the low refractive index layer and an accommodation part 113 for accommodating a vapor deposition source 113a for forming the high refractive index layer. Specifically, the accommodation part 112 is provided with a crucible (not shown) for accommodating the vapor deposition source 112a and the accommodation part 113 is provided with another crucible (not shown) for receiving the vapor deposition source 113a.

Any of the vapor deposition sources (metal oxide) accommodated in the crucible is irradiated with thermions 114 by an electron gun (not shown) to cause evaporation, thereby successively forming respective layers on the lens sample 10. In the present example, granules of SiO₂ were used as the vapor deposition source 112a while a sintered compact of ZrO₂ (tablet) was used as the vapor deposition source 113a.

The vapor deposition apparatus 100 further includes an ion gun 118 for ionizing and accelerating gas introduced to an inner part of the vacuum chamber 110 and irradiating the lens sample 10 therewith in order to enable ion assisted deposition. The vacuum chamber 110 may further include a cold trap for removing residual water, a device for managing the layer thickness, or the like. The device for managing the layer thickness may be, for example, an optical thickness meter of a reflection type or a crystal oscillator thickness meter.

The inner part of the vacuum chamber 110 can be maintained in a high vacuum state, for example at 1 x 10⁻⁴ Pa, by a turbo molecular pump or a cryopump 121 and a pressure adjustment valve 122 included in the exhaust device 120. Meanwhile, the inner part of the vacuum chamber 110 can also be caused to be in predetermined gas atmosphere by the gas supply device 130. For example, a gas container 131 included in the gas supply device 130 contains argon (Ar), nitrogen (N₂), oxygen (O₂), etc. The flow rate of gas can be controlled by a flow rate control device 132. The internal pressure of the vacuum chamber 110 can be controlled by a pressure gauge 135.

Major vapor deposition conditions in the vapor deposition apparatus 100 includes a vapor deposition material, acceleration voltage and a current value of the electron gun, and whether ion assist is performed. Conditions where an ion assist is used are given by a type of ion (atmosphere in the vacuum chamber 110), an acceleration voltage value and an ion current value of the ion gun 118. Hereinafter, the acceleration voltage and current value of the electron gun are within a range of 5 to 10 kV and a range of 50 to 500 mA, respectively, based on a film forming rate or the like unless otherwise specified. Further, when the ion assist is used, the voltage value and current value of the ion gun 118 are within a range of 200 V to 1 kV and a range of 100 to 500 mA, respectively, based on a film forming rate or the like.

Next, pretreatment to apply to a surface (surface of the hard coat layer) to be deposited before performing vapor deposition will be described.

The lens sample 10 formed with the hard coat layer was washed with acetone. The lens sample 10 was then subjected to heating processing at approximately 70°C in the vacuum chamber 110 to evaporate water attached thereto. Next, a surface of the lens sample 10 was subjected to ion cleaning. Specifically, the surface of the lens sample 10 was irradiated with an oxygen ion beam at an energy of several hundreds electron volts using the ion gun 118 and an organic matter attached to the surface of the lens sample 10 was removed. This processing (method) allows for improving adhesion of a layer (film) to be formed on the surface of the lens sample 10. Note that a similar processing may be performed using inert gas such as argon (Ar) gas or xenon (Xe) gas or nitrogen (N₂) instead of oxygen ion. Alternatively, the surface of the lens sample 10 may be irradiated with an oxygen radical or oxygen plasma.

Next, a method of forming a multilayer film on an object-side surface where the aforementioned pretreatment has been applied to will be described.

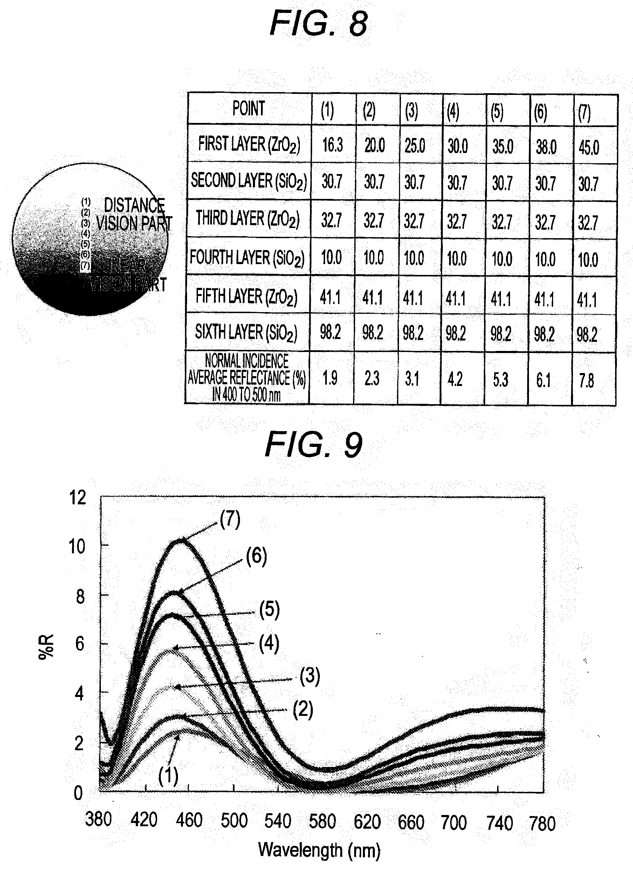

A configuration (design value) of the multilayer film formed here is illustrated in Fig. 8. The object-side surface (convex surface) includes a configuration of (1) to (7) while the eyeball-side surface (concave surface) includes a configuration of (1). The points (1) to (3), (4), and (5) to (7) each correspond to points positioned in the upper region during use, a fitting point during use, and points positioned in the lower region during use, respectively. As illustrated in Fig. 8, a first layer of high refractive index layer has a thickness gradually increasing from the portion positioned upward to the portion positioned downward during use.

The inner part of the vacuum chamber 110 was sufficiently evacuated. Thereafter, a vapor deposition step was repeated where the high refractive index layer and low refractive index layer were alternately laminated on the object-side surface of the lens sample 10 by an electron beam vacuum vapor deposition method, thereby forming a multilayer film including six layers in total. An SiO₂ layer of the low refractive index layer was formed without performing ion assist. Specifically, heating conditions with the electron beam were a voltage of 6 kV and a current of 100 mA. Here, argon gas was introduced inside the vacuum chamber 110 at 5 sccm. Meanwhile, a ZrO₂ layer of the high refractive index layer was formed by performing ion assist (ion assisted deposition). Specifically, heating conditions with the electron beam were a voltage of 6 kV and a current of 280 mA. Here, mixed gas of argon gas and oxygen gas was used for ion assist and a mixed beam of argon and oxygen was emitted at an ion acceleration voltage of 600 V and an ion beam current of 150 mA. No gas was introduced into the vacuum chamber 110.

Moreover, the vapor deposition step of the first layer of high refractive index layer (ZrO₂ layer) was performed while a mechanical mask (shielding member) was disposed over a distance vision region positioned upward from the fitting point during use as illustrated in Fig. 2A. The shielding member was disposed over the lens with a space therebetween using a holder not shown. By disposing the shielding member over the lens with a space therebetween, a boundary between the upper region and lower region becomes unclear. This also enables forming the deposition layer with a successively varying thickness. A schematic plane view of a mechanical mask used here is illustrated in Fig. 7. Since a shape of a portion, opposite to the boundary between the upper region and lower region in the surface to be deposited, is not linear but comb-shaped, the boundary between the upper region and lower region in the deposition layer is unclear as compared to a case where the shape is linear. This is preferable for obtaining a spectacle lens with a preferable appearance. A similar effect can also be gained by a shielding member having a shape including curves such as a waveform in the portion opposite to the boundary between the upper region and lower region in the surface to be deposited.

As the first layer, ZrO₂ was deposited by a thickness given by a difference between (7) and (1) in Fig. 8, namely, 45.0 nm - 16.3 nm = 28.7 nm.

Thereafter, the vapor deposition apparatus was once released to remove the mechanical mask therefrom. Evacuation was then again performed and vapor deposition was restarted. The remaining thickness of 16.3 nm for the first layer was deposited and a second and subsequent layers were deposited thereon.

Thicknesses at seven points on a linear line passing through fitting points in the respective layers of the multilayer film having been form in such a manner correspond to values of (1) to (7) illustrated in Fig. 7.

Next, the lens sample formed with the multilayer film on the eyeball-side surface was turned upside down and mounted to the vapor deposition apparatus. A multilayer film was then formed on the object-side surface (concave surface) in a similar manner as above. In this step, the mechanical mask was not used but a film with a uniform thickness was deposited on the entire surface. Specifically, vapor deposition was performed successively from a first layer to a sixth layer with a configuration of (1) in Fig. 7.

As a result of the above steps, the spectacle lens including, on both of the lens surfaces, multilayer films having a characteristic of reflecting blue light was obtained. In this spectacle lens, the multilayer film on the object-side surface has varying thicknesses in the first layer as illustrated in Fig. 8.

### 1-3. Measurement of reflection characteristic and transmission characteristic

Normal incidence reflection spectral characteristics were measured in a wavelength region of 380 to 780 nm using Olympus Micro Spectrophotometer USPM in the aforementioned seven points on the eyeball-side surface (concave surface side) of the manufactured spectacle lens. Normal incidence average reflectances in a wavelength region of 400 to 500 nm in the aforementioned seven points are shown in Fig. 8 while an obtained reflection spectrum is shown in Fig. 9. A normal incidence average reflectance in the wavelength region of 400 to 500 nm at the fitting point on the object-side surface was 1.9%, which is same as that in the point (1) in Fig. 8.

Note that the reflection spectrum shown in Fig. 9 was obtained by measuring a normal incidence reflectance for every 10 nm within the wavelength of 380 to 780 nm (wavelength interval of 10 nm). However, the wavelength interval for measurement can be set arbitrary upon measuring reflection characteristic and transmission characteristic and may be set at, for example, 1 nm. As shown in Fig. 9, a normal incidence reflectance in the wavelength region of 400 to 500 nm can be confirmed to gradually increase from the portion positioned upward to the portion positioned downward during use.

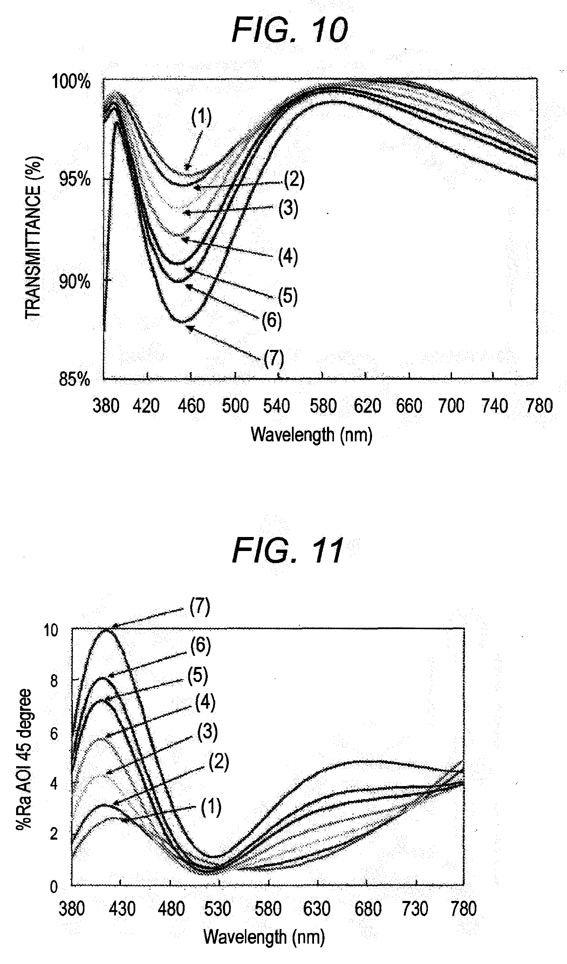

Normal incidence transmission spectral characteristics (ratio of an amount of light transmitted by the eyeball-side surface to an amount of light incident on the object-side surface) were measured in the wavelength region of 380 to 780 nm using Hitachi Spectrophotometer U-4100 in the aforementioned seven points in the manufactured spectacle lens.(wavelength interval of 10 nm). An obtained transmission spectrum is shown in Fig. 10. From the result shown in Fig. 10, the amount of blue light, which enters the eye of the spectacle wearer after entering from the object-side surface and being transmitted by the eyeball side, can be confirmed to have reduced in the lower region of the spectacle lens as compared to the upper region. When a spectacle wearer looks at a source of blue light (a monitor screen or the like of digital devices such as a personal computer, smartphone, and tablet terminal), the lower region is mainly used. Thus, reducing the amount of blue light incident on the eye of the spectacle wearer in this region allows for effectively mitigating burden caused by blue light to the eye.

Fig. 11 shows a spectrum of reflection light, reflected in the respective points in the eyeball-side surface including return light reflected by the object-side surface, of light irradiated to the eyeball-side surface from a fluorescent light arranged in the upper side at an inclination of 45° from the horizontal direction when the manufactured spectacle lens is erected with the upper region upward and the lower region downward. Normal incidence reflection spectral characteristics were converted using an incident angle of 45°, thereby obtaining an average value for reflection light of P polarization and reflection light of S polarization in the wavelength region of 380 to 780 nm and developing the spectrum.

The spectacle lens of the present example includes coating films having a characteristic of reflecting light in the wavelength region of 400 to 500 nm on both of the lens surfaces; however, a portion positioned in an upper side has a smaller reflectance of light in the wavelength region as illustrated in Fig. 11. Such a spectacle lens can prevent light incident on the eyeball-side of the spectacle lens from the upper rear side of the spectacle wearer from entering the eye of the spectacle wearer especially as reflection light or return light from the upper side of the spectacle lens and thereby deteriorating wearing feeling of the spectacles.

### [Example 2]

### 2-1. Formation of multilayer film on object-side surface and eyeball-side surface

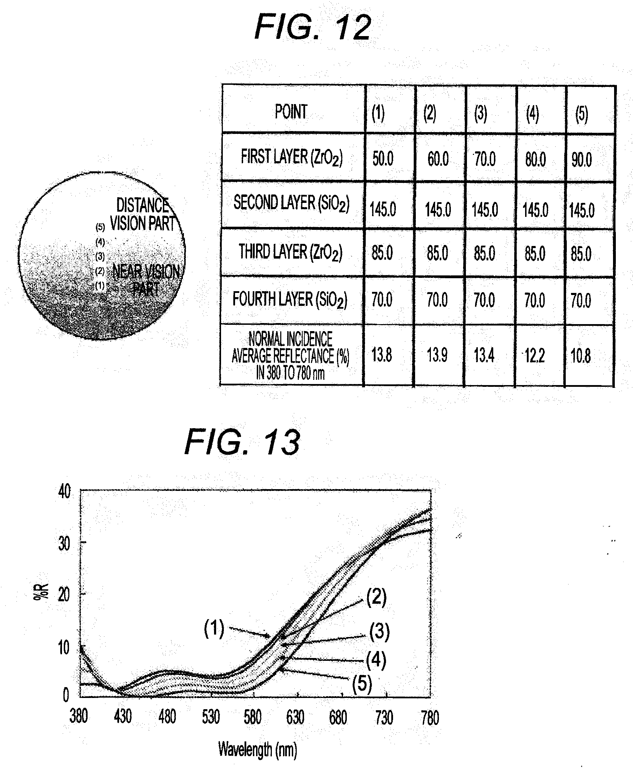

Multilayer films were formed on an object-side surface and eyeball-side surface in a similar manner to Example 1, except for that a film material and film thickness have been changed as illustrated in Fig. 12, thereby obtaining the spectacle lens according to the aspect B-1. Note that the multilayer film on the object-side surface has the configuration of (5) in Fig. 12.

### 2-2. Measurement of reflection characteristic and transmission characteristic

Normal incidence reflection spectral characteristics were measured in the wavelength region of 380 to 780 nm using Olympus Micro Spectrophotometer USPM in the aforementioned five points on the eyeball-side surface (concave surface side) of the manufactured spectacle lens. Normal incidence average reflectances in a wavelength region of 380 to 780 nm in the aforementioned five points are shown in Fig. 12 while an obtained reflection spectrum is shown in Fig. 13. A normal incidence average reflectance in the wavelength region of 380 to 780 nm at the fitting point on the object-side surface was 10.8%, which is same as that in the point (5) in Fig. 13.

Note that the reflection spectrum shown in Fig. 13 was obtained by measuring a normal incidence reflectance for every 10 nm within the wavelength of 380 to 780 nm (a wavelength interval of 10 nm). However, the wavelength interval for measurement can be set arbitrary upon measuring reflection characteristic and transmission characteristic and may be set at, for example, 1 nm.

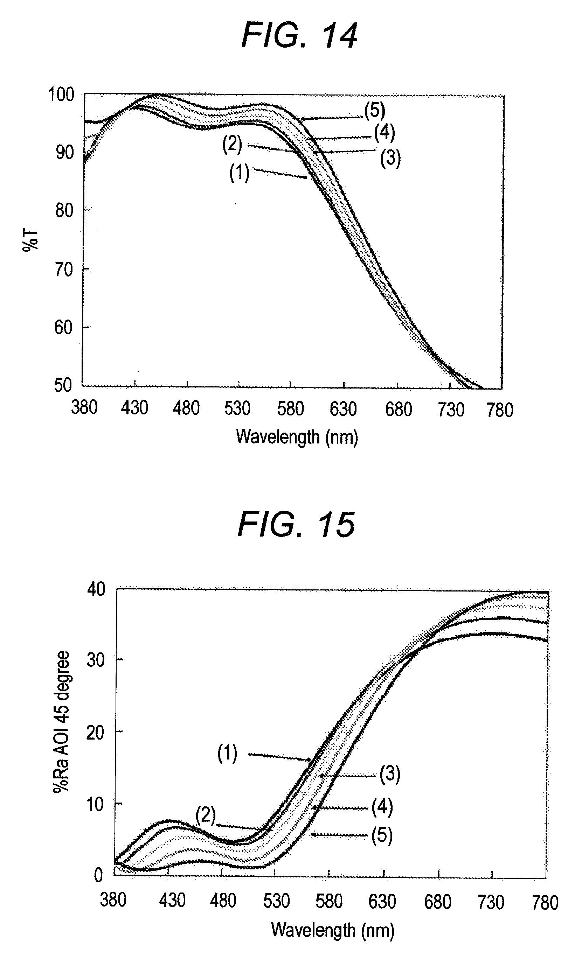

A normal incidence transmission spectral characteristic (ratio of an amount of light transmitted by the eyeball-side surface to an amount of light incident on the object-side surface) was measured in the wavelength region of 380 to 780 nm using Hitachi Spectrophotometer U-4100 in the aforementioned five points in the manufactured spectacle lens (wavelength interval of 10 nm). An obtained transmission spectrum is shown in Fig. 14.

Fig. 15 shows a spectrum of reflection light, reflected in the respective points in the eyeball-side surface including return light reflected by the object-side surface, of light irradiated to the eyeball-side surface from a fluorescent light arranged in the upper side at an inclination of 45° from the horizontal direction when the manufactured spectacle lens is erected with the upper region upward and the lower region downward. Normal incidence reflection spectral characteristics were converted using an incident angle of 45°, thereby obtaining an average value for reflection light of P polarization and reflection light of S polarization in the wavelength region of 380 to 780 nm and developing the spectrum.

As illustrated in Fig. 15, a portion positioned in an upper side has a smaller reflectance also in the spectacle lens of the present example. Therefore, light incident on the eyeball-side of the spectacle lens from the upper rear side of the spectacle wearer can be prevented from entering the eye of the spectacle wearer especially as reflection light or return light from the upper side of the spectacle lens and thereby deteriorating wearing feeling of the spectacles.

### Industrial Applicability

The present invention is useful in the field of manufacturing spectacle lenses.

## Claims

1. A spectacle lens, comprising:
a lens base material; and
coating films, having a characteristic of reflecting light in a specific wavelength region, on both of an object-side surface and an eyeball-side surface of the lens base material,
wherein one or both of the coating films on the surfaces have a reflectance gradient where a reflectance of the light decreases successively or gradually from a portion positioned downward to a portion positioned upward during use or from the portion positioned upward to the portion positioned downward during use.

2. The spectacle lens according to claim 1,
wherein the lens base material is a minus lens where a thickness in a center part is thinner than a thickness in a peripheral part, and
the coating film, having a reflectance gradient where a reflectance of the light decreases successively or gradually from the portion positioned downward to the portion positioned upward during use, is provided on the object-side surface.

3. The spectacle lens according to claim 1,
wherein the lens base material is a minus lens where a thickness in a center part is thinner than a thickness in a peripheral part,
the coating film, having a reflectance gradient where a reflectance of the light decreases successively or gradually from the portion positioned downward to the portion positioned upward during use or from the portion positioned upward to the portion positioned downward during use, is provided on the eyeball-side surface, and
the coating film without a reflectance gradient is provided on the object-side surface.

4. The spectacle lens according to claim 3,
wherein the coating film on the eyeball-side surface has a higher or lower normal incidence average reflectance in the specific wavelength region in a lower region positioned downward from a fitting point or an optical center during use than a normal incidence average reflectance in the specific wavelength region in an upper region positioned upward from the lower region, and
the normal incidence average reflectance in the specific wavelength region of the coating film on the object-side surface is lower than or equal to the normal incidence average reflectance in a region having a low normal incidence average reflectance in the upper region or lower region of the coating film on the eyeball-side surface.

5. The spectacle lens according to claim 1,
wherein the lens base material is a plus lens where a thickness in a center part is thicker than a thickness in a peripheral part, and
the coating film, having a reflectance gradient where a reflectance of the light decreases successively or gradually from the portion positioned downward to the portion positioned upward during use, is provided on the eyeball-side surface.

6. The spectacle lens according to claim 1,
wherein the lens base material is a plus lens where a thickness in a center part is thicker than a thickness in a peripheral part,
the coating film, having a reflectance gradient where a reflectance of the light decreases successively or gradually from the portion positioned downward to the portion positioned upward during use or from the portion positioned upward to the portion positioned downward during use, is provided on the object-side surface, and
the coating film without a reflectance gradient is provided on the eyeball-side surface.

7. The spectacle lens according to claim 6,
wherein the coating film on the object-side surface has a higher or lower normal incidence average reflectance in the specific wavelength region in a lower region positioned downward from a fitting point or an optical center during use than a normal incidence average reflectance in the specific wavelength region in an upper region positioned upward from the lower region, and
the normal incidence average reflectance in the specific wavelength region of the coating film on the eyeball-side surface is lower than or equal to the normal incidence average reflectance in a region having a low normal incidence average reflectance in the upper region or lower region of the coating film on the object-side surface.
